Europäisches Patentamt

European Patent Office

Office européen des brevets

(11) Publication number: **0 106 044 B1**

(12) **EUROPEAN PATENT SPECIFICATION**

(45) Date of publication of patent specification: **17.07.91**  (51) Int. Cl.⁵: **H01L 29/80**

(21) Application number: **83107607.0**

(22) Date of filing: **02.08.83**

(54) Space charge modulating semiconductor device and circuit comprising it.

(30) Priority: **17.09.82 US 419381**

(43) Date of publication of application:
**25.04.84 Bulletin 84/17**

(45) Publication of the grant of the patent:
**17.07.91 Bulletin 91/29**

(84) Designated Contracting States:
**DE FR GB**

(56) References cited:
**US-A- 4 141 021**
**US-E- 29 971**

(73) Proprietor: **International Business Machines Corporation**
**Old Orchard Road**
**Armonk, N.Y. 10504(US)**

(72) Inventor: **Freeouf, John Lawrence**
**Rt. 3, Box 121**
**Peekskill New York 10566(US)**
Inventor: **Jackson, Thomas Nelson**
**2 Feeney Road**
**Ossining New York 10562(US)**
Inventor: **Laux, Steven Eric**
**Pines Bridge Road RFD No 4**
**Mount Kisco New York 10549(US)**
Inventor: **Woodall, Jerry Mac Pherson**
**336 Cherry Street**
**Bedford Hills New York 10507(US)**

(74) Representative: **Bailey, Geoffrey Alan**
**IBM United Kingdom Limited Intellectual Property Department Hursley Park**
**Winchester Hampshire SO21 2JN(GB)**

## Description

This invention relates to semiconductor devices.

The invention seeks to provide a semiconductor device in which electrical conduction between a pair of contacts is controlled by space charge modulation effected via a third contact.

US-E-29 971 discloses (in particular in Fig. 8 thereof) a semiconductor device of the JFET type which has a body comprising two contiguous semiconductor regions of opposite conductivity type with a rectifying junction therebetween. First and second contacts are made to the two semiconductor regions. A third contact is disposed on the semiconductor body in a position remote from the first and second contacts.

The invention provides a semiconductor device comprising first and second contacts disposed on one side of a semiconductor body, the second contact being a rectifying contact, and a third contact disposed on the semiconductor body in a position remote from the first and second contacts, the first contact having a dimension substantially equal to or less than the Debye length (as defined herein) in the semiconductor of the body, the second contact being disposed a distance substantially equal to or less than the said Debye length from the first contact, the semiconductor body being of a single conductivity type, and the second contact being shorted together with the third contact thereby providing a diode characteristic between the first contact and the third and second contacts.

How the invention can be carried out will now be described by way of example, with reference to the accompanying drawings, in which:-

FIG. 1 represents a semiconductor device;
FIG. 2 is a diagram of one circuit configuration employing the device of FIG. 1;
FIG. 3 is a current voltage characteristic obtained with the circuit configuration of FIG. 2;
FIG. 4 is a diagram of another circuit configuration employing the device of FIG. 1 in accordance with the invention;
FIG. 5 is a current voltage characteristic obtained with the circuit configuration of FIG. 4;

In accordance with the invention, a rectifying contact is placed within a Debye length of a second contact of the order of a Debye length in size on one surface of a semiconductor body and a third contact is placed elsewhere on the same semiconductor body. Under proper biasing the space charge in the semiconductor body under the rectifying contact can control the conduction between the other two contacts.

The Debye length is a characteristic distance in semiconductors. It is defined and discussed in the text "Physics of Semiconductor Devices" by S.

M. Sze, Second Edition, pages 77 and 78, published by Wiley, N.Y., ie,

$$L_D = /(E_S kT/q^2 N_B)$$

where $L_D$ = Debye length, $E_S$ = permittivity of the semiconductor,
k = Boltzmann constant, q = charge of charge carrier and
$N_B$ = charge carrier density.

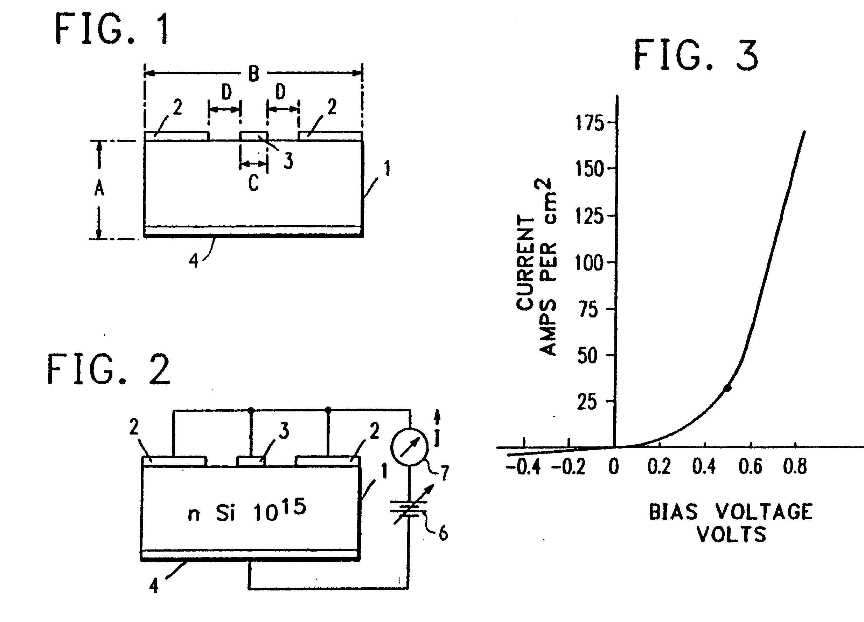

An embodiment of a semiconductor device is represented in FIG. 1 wherein on one surface of a semiconductor body 1 there is positioned an intrinsically rectifying contact 2. The intrinsic conducting behaviour of a contact may be defined as the two-terminal current voltage behaviour of the contact when that contact is forming a two-terminal device with the substrate. The rectifying contact 2 surrounds or is parallel with a small width intrinsically ohmic contact 3 positioned a distance D from the rectifying contact 2. The dimension D is about equal to or less than the extrinsic Debye length of the semiconductor of body 1. The contact 3 has a dimension C that is also about equal to or less than the Debye length. A third, ohmic contact 4 is positioned a distance A from the contacts 2 and 3 on the opposite side of the semiconductor body 1.

The semiconductor of body 1 should be of sufficiently high resistivity to permit the space charge under the rectifying contact 2 to penetrate a physical distance into the semiconductor under moderate voltage levels to affect carrier flow between the contacts 3 and 4.

The semiconductor body 1 may be of silicon doped with $10^{15}$ impurity atoms per cubic centimeter. With this resistivity and dimensions maintained at C and D less than approximately 0.1 micrometers, the polarity of the signal on the contact 2 will affect current flow between contacts 3 and 4.

The device of FIG. 1 is preferably fabricated by using Schottky barrier contacts with different barrier heights so that ohmic or rectifying behavior is produced. Where the semiconductor 1 is silicon doped to about $10^{15}$ atoms per cubic centimeter with conductivity type n, the ohmic contacts 3 and 4 may be obtained using a relatively low barrier Schottky contact where that barrier height is about 0.2 to 0.3 eV. Such contacts can be obtained through the use of rare earth silicides as set forth in IBM Technical Disclosure Bulletin, Vol. 21, p. 2811. The rectifying contact 2 can be formed using a higher barrier Schottky contact. For a rectifying contact, the barrier height should be of the order of 0.8 eV, such as is obtainable with Au or PtSi on a silicon substrate.

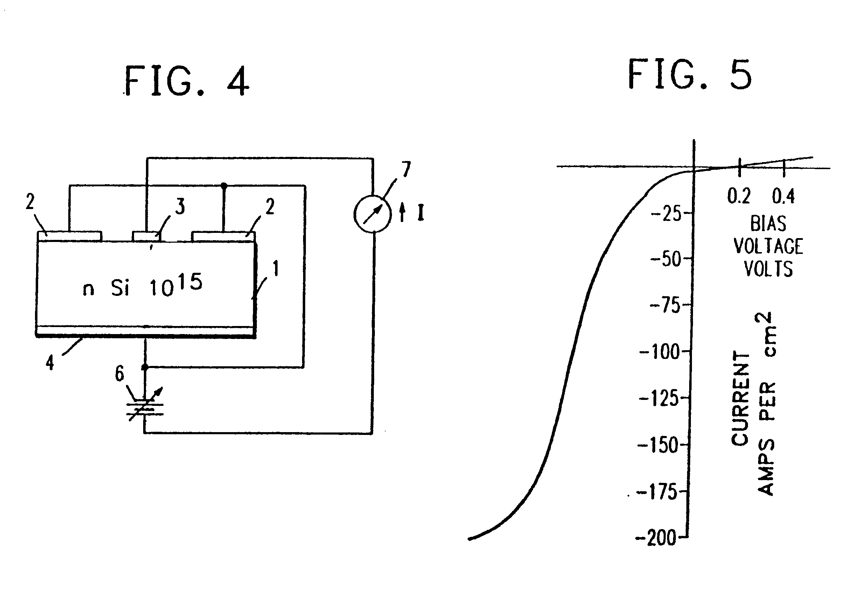

An illustration of the operation of the device may be seen in connection with FIGS. 2 through 5 wherein FIGS. 2 and 3 illustrate a circuit and corresponding performance in one polarity and FIGS. 4 and 5 illustrate a circuit and corresponding performance in an opposite polarity.

Referring to FIG. 2 using a battery 6 of about 1.5 volts as a source of power, the semiconductor body 1 has one ohmic contact 4 connected to the battery 6 and the other ohmic contact 3 and rectifying contact 2 connected through a current indicator 7 to the other side of the battery 6.

Under these conditions a space charge under the rectifying contact 2 will penetrate the high resistivity body 1 far enough to affect the conductivity through the body 1 between the ohmic contacts 3 and 4.

In the body 1 of the device, for a voltage equal to zero, the depletion depth in $10^{15}$ atoms per cc n-type silicon radiating from contact 2 would deplete the area below contact 3 when positioned lateral to contact 2 for the intergap D of about 500Å and contact size C of 0.15 micrometers. These dimensions result in the distance from the edge of the contact 2 to the center of contact 3 being of the order of a Debye length in semiconductor material of this resistivity. This would not permit any significant current flow between contacts 3 and 4.

Where the voltage is selected to be greater than zero, the depletion depth radiating from contact 2 would decrease thus allowing a clear conducting path of electrons between contacts 3 and 4. By appropriate choice of size for contact 3 and for the gap between contacts 2 and 3, that portion of the current through contact 3 dominates the flow for voltages of the order of 0.6V. Hence, a high impedance is maintained at contact 2 and a low impedance between contacts 3 and 4. Where the impressed voltage from battery 6 is less than zero, the depletion width will radiate even more below contact 2 than for the V = 0 case and the current flow between contacts 3 and 4 will be very small.

Referring next to FIG. 3, there is shown the current voltage (I-V) characteristic curve for the circuit of FIG. 2. It will be apparent to one skilled in the art that the the curve of FIG. 3 is similar to that of an ordinary I-V curve for a diode. Since the silicon of the body 1 is doped n-type in this example, the IV characteristic of contact 3 is qualitatively that of a normal Schottky diode as shown in FIG. 3.

Using the device of the invention, it is also possible to provide an opposite or reverse diode characteristic. This is illustrated in connection with the circuit of FIG. 4 and the current voltage (IV) output characteristic of FIG. 5. In FIG. 4 the circuit configuration is such that the rectifying contact or contact segments 2 and the ohmic contact 4 are shorted together and the ohmic contact 3 is held at a positive potential with the battery 6. The (IV) characteristic of FIG. 5 is achieved by varying the voltage V of the battery 6 and observing the current flow through the current indicator 7.

Under these conditions, for V = 0, the depletion depth below contacts 2 and 3 remains as configured for the forward diode. However, for the condition V < 0, the electron accumulation situated directly below contact 3 as a result of a standard ohmic $n^+$ doping pocket or below the low barrier height of contact 3 is pushed farther into the semiconductor, effectively parting the depletion layers radiating from contact 2. This provides a clear path for electron flow between contacts 3 and 4.

For the condition where V > 0, the electron accumulation present below contact 3 is pulled closer to contact 3 than the previously described V = 0 case and no significant path of electron conduction exists between contacts 3 and 4.

The I-V characteristic corresponding to the circuit configuration of FIG. 4 is shown in FIG. 5. The characteristic polarity is clearly reversed and is in marked contrast to that of FIG. 3. The impedance of contact 2 also remains high in this reversed diode case.

In essence, the three-terminal device of the invention implements a reversing diode concept in that the polarity of conduction between the two contacts 3 and 4 is determined by the potential that is present on a high impedance contact 2.

## Claims

1. A semiconductor device comprising first and second contacts (3,2) disposed on one side of a semiconductor body (1), the second contact (2) being a rectifying contact, and a third contact (4) disposed on the semiconductor body in a position remote from the first and second contacts, the first contact having a dimension (C) substantially equal to or less than the Debye length (as defined herein) in the semiconductor of the body, the second contact being disposed a distance (D) substantially equal to or less than the said Debye length from the first contact, the semiconductor body being of a single conductivity type, and the second contact being shorted together with the third contact thereby providing a diode characteristic between the first contact and the third and second contacts.

2. A semiconductor device as claimed in claim 1, in which the first and third contacts (3,4) are ohmic contacts.

3. A semiconductor device as claimed in claim 1 or claim 2, in which the third contact (4) is a broad area contact disposed on the opposite side of the body (1) to that on which the first and second contacts (3,2) are disposed.

4. A semiconductor device as claimed in any preceding claim, in which said dimension (C) of the first contact is about 0.15 $\mu$m and in which the second contact is disposed about 50nm (500Å) from the first contact.

5. A semiconductor device as claimed in any preceding claim, in which the first contact (3) is a Schottky barrier contact with a relatively low barrier height and the second contact (2) is a Schottky barrier contact with a relatively high barrier height.

6. A semiconductor device as claimed in claim 5, in which the first contact (3) has a barrier height of from 0.2 to 0.3 eV and the second contact (2) has a barrier height of about 0.8 eV.

7. A semiconductor device as claimed in any preceding claim, in which the semiconductor body (1) is of n-type silicon doped with $10^{15}$ impurity atoms per cubic centimetre.

8. A circuit including a semiconductor device as claimed in any preceding claim.

## Revendications

1. Dispositif semi-conducteur comprenant des premier et deuxième contacts (3, 2) disposés sur un premier côté d'un corps semi-conducteur (1), le deuxième contact (2) étant un contact de redressement, et un troisième contact (4) disposé sur le corps semi-conducteur dans une position éloignée des premier et deuxième contacts, le premier contact étant de dimension (C) rigoureusement égale ou inférieure à la longueur de Debye (telle qu'elle est définie ici) dans le semi-conducteur du corps, le deuxième contact étant disposé à une distance (D) rigoureusement égale ou inférieure à ladite longueur de Debye à partir du premier contact, le corps semi-conducteur étant d'un seul type de conductivité, et le deuxième contact étant monté en court-circuit avec le troisième contact, fournissant de ce fait une caractéristique de diode entre le premier contact et les troisième et deuxième contacts.

2. Dispositif semi-conducteur selon la revendication 1, dans lequel les premier et troisième contacts (3, 4) sont des contacts ohmiques.

3. Dispositif semi-conducteur selon la revendication 1 ou la revendication 2, dans lequel le troisième contact(4) est un contact de grande surface disposé sur le côté du corps (1) opposé à celui sur lequel sont disposés les premier et deuxième contacts (3, 2).

4. Dispositif semi-conducteur selon l'une quelconque des revendications précédentes, dans lequel la dimension (C) du premier contact est d'environ 0,15 $\mu$m et dans lequel le deuxième contact est disposé à environ 50 nm (500 Angströms) du premier contact.

5. Dispositif semi-conducteur selon l'une quelconque des revendications précédentes, dan lequel le premier contact (3) est un contact à barrière de Schottky avec une hauteur de barrière relativement faible, et le deuxième contact (2) est un contact à barrière de Schottky avec une hauteur de barrière relativement élevée.

6. Dispositif semi-conducteur selon la revendication 5, dans lequel le premier contact (3) a une hauteur de barrière allant de 0,2 à 0,3 eV, et le deuxième contact (2) a une hauteur de barrière d'environ 0,8 eV.

7. Dispositif semi-conducteur selon l'une quelconque des revendications pécédentes, dans lequel le corps semi-conducteur est du silicium de type n dopé avec $10^{15}$ atomes d'impuretés par centimètre cube.

8. Circuit comprenant un dispositif semi-conducteur selon l'une quelconque des revendications précédentes.

## Patentansprüche

1. Halbleiterbauelement mit ersten und zweiten Kontakten (3,2), die an einer Seite eines Halbleiterkörpers (1) angeordnet sind, wobei der zweite Kontakt (2) ein gleichrichtender Kontakt ist und mit einem dritten Kontakt (4), der an dem Halbleiterkörper in einer von den ersten und zweiten Kontakten entfernten Lage angeordnet ist, wobei der erste Kontakt eine Abmessung (C) aufweist, die im wesentlichen gleich oder kleiner ist, als die Debye-Länge (wie hierin definiert) in dem Halbleiter des Körpers, der zweite Kontakt in einem Abstand (D), der im wesentlichen gleich oder kleiner ist, als die Debye-Länge, von dem ersten Kontakt angeordnet ist, der Halbleiterkörper eine einzige Leitfähigkeitsart aufweist und der zweite Kontakt zusammen mit dem dritten Kontakt kurzgeschlossen ist, wodurch eine Dioden-Charakteristik zwischen dem ersten Kontakt und den dritten und zweiten Kontakten geliefert wird.

2. Halbleiterbauelement nach Anspruch 1, bei welchem die ersten und dritten Kontakte (3, 4) ohmsche Kontakte sind.

3. Halbleiterbauelement nach Anspruch 1 oder 2, bei welchem der dritte Kontakt (4) ein großflächiger Kontakt ist, der an der jener Seite gegenüberliegenden Seite des Körpers (1) angeordnet ist, an welcher die ersten und zweiten Kontakte (3, 2) angeordnet sind.

4. Halbleiterbauelement nach irgend einem vorgehenden Anspruch, bei welchem die Abmessung (c) des ersten Kontaktes ungefähr 0,15 $\mu$m beträgt und bei welchem der zweite Kontakt ungefähr 50 nm (500 Å) von dem ersten Kontakt angeordnet ist.

5. Halbleiterbauelement nach irgend einem vorgehenden Anspruch, bei welchem der erste Kontakt (3) ein Schottky-Barriere-Kontakt mit einer verhältnismäßig kleinen Barrierehöhe ist und der zweite Kontakt (2) ein Schottky-Barriere-Kontakt mit einer verhältnismäßig großen Barrierehöhe ist.

6. Halbleiterbauelement nach Anspruch 5, bei welchem der erste Kontakt (3) eine Barrierehöhe von 0,2 bis 0,3 eV und der zweite Kontakt (2) eine Barrierehöhe von etwa 0,8 eV aufweist.

7. Halbleiterbauelement nach irgend einem vorgehenden Anspruch, bei welchem der Halbleiterkörper (1) n-Typ Silizium ist, das mit $10^{15}$ Fremdatomen pro Kubikzentimeter dotiert ist.

8. Schaltung mit einem Halbleiterbauelement nach irgend einem vorgehenden Anspruch.

FIG. 1

FIG. 2

FIG. 3

EP 0 106 044 B1

# FIG. 4

n Si $10^{15}$

# FIG. 5

0.2  0.4
BIAS
VOLTAGE
VOLTS

-25
-50
-75
-100
-125
-150
-175
-200

CURRENT AMPS PER cm$^2$

EP 0 106 044 B1